# EUROPÄISCHE PATENTSCHRIFT

(11) **EP 2 548 421 B1**
(45) Veröffentlichungstag und Bekanntmachung des Hinweises auf die Patenterteilung: **25.02.2015**
(21) Anmeldenummer: 11709694.1
(22) Anmeldetag: 16.03.2011
(51) Int. Cl.: H05K 1/18, H05K 3/32

(54) **ANORDNUNG MIT EINEM ELEKTRISCHEN UND/ODER ELEKTRONISCHEN MODUL UND EINEM SCHALTUNGSTRÄGER**
ARRANGEMENT COMPRISING AN ELECTRIC AND/OR ELECTRONIC MODULE AND A CIRCUIT CARRIER
ENSEMBLE COMPORTANT UN MODULE ÉLECTRIQUE ET/OU ÉLECTRONIQUE ET UN SUPPORT DE CIRCUIT

(30) Priorität: 17.03.2010 DE 102010002943
(43) Veröffentlichungstag der Anmeldung: 23.01.2013
(73) Patentinhaber: Robert Bosch GmbH, 70442 Stuttgart (DE)
(72) Erfinder: HEIM, Michael, 71088 Holzgerlingen (DE); BRAUN, Sigmund, 72127 Kusterdingen (DE)
(86) Internationale Anmeldenummer: PCT/EP2011/053976
(87) Internationale Veröffentlichungsnummer: WO 2011/113863

(56) Entgegenhaltungen:
- WO-A1-01/45212
- US-A- 3 487 350
- US-A- 4 037 899
- US-A- 5 928 005

## Beschreibung

### Stand der Technik

Die Erfindung geht aus von einer Anordnung mit einem elektrischen und/oder elektronischen Modul und einem Schaltungsträger nach der Gattung des unabhängigen Patentanspruchs 1.

Zur elektrischen Kontaktierung von Anschlussleitungen bzw. Anschlussdrähten an einen Schaltungsträger kommen bei der Montage von elektrischen und/oder elektronischen Modulen üblicherweise Lötverfahren oder die so genannte Einpresstechnik zum Einsatz. Beim Lötverfahren wird üblicherweise auf den Schaltungsträger ein Lotpastendepot durch unterschiedliche Verfahren, wie beispielsweise Schablonendruck oder Dispensen aufgebracht und anschließend wird der Anschlussdraht beispielsweise durch ein Reflowlötverfahren oder ein Selektivlötverfahren verlötet. Dazu müssen die entsprechenden Anschlussdrähte in der Regel eine lötbare Oberfläche aufweisen, also entsprechend beschichtet sein. Soll die Kontaktierung bereits im teilweise aufgebauten Zustand des elektrischen und/oder elektronischen Moduls erfolgen, so müssen die Kontaktierstellen für das anzuwendende Lötverfahren jedoch zugänglich sein. Dies ergibt Einschränkungen bezüglich der konstruktiven Ausgestaltung des elektrischen und/oder elektronischen Moduls sowie des Fertigungsflusses. Bei der so genannten Einpresstechnik wird eine speziell ausgeformte, flexible so genannte Einpresszone am Anschlussdraht angebracht und in eine in der Leiterplatte angeordnete Hülse eingepresst. Diese Einpresstechnik stellt jedoch gewisse Anforderungen an die Toleranzen, insbesondere hinsichtlich der Einpresstiefe bei der Montage.

In der Offenlegungsschrift DE 10 2007 041 904 A1 ist beispielsweise eine Anordnung mit einem elektrischen und/oder elektronischen Modul und einem Schaltungsträger beschrieben, bei welcher mindestens eine elektrische Anschlussleitung des elektrischen und/oder elektronischen Moduls in Form eines so genannten Durchsteckkontaktes in einer Ausnehmung des Schaltungsträgers aufnehmbar ist. Anschließend wird der Anschlussdraht des Moduls beispielsweise durch ein Reflowlötverfahren in der Ausnehmung des Schaltungsträgers verlötet.

In den Dokumenten US 4,037,899, US 5,928,005, US 3,487,350 und WO 01/45212 A1 wird jeweils eine Anordnung mit einem elektrischen und/oder elektronischen Modul und einem Schaltungsträger beschrieben. Bei den beschriebenen Anordnungen ist mindestens eine elektrische Anschlussleitung des elektrischen und/oder elektronischen Moduls in einer Ausnehmung des Schaltungsträgers aufgenommen, wobei zumindest eine Klemmeinrichtung die mindestens eine Anschlussleitung nach dem Einführen in die Ausnehmung in der Ausnehmung fixiert.

### Offenbarung der Erfindung

Die erfindungsgemäße Anordnung mit einem elektrischen und/oder elektronischen Modul und einem Schaltungsträger mit den Merkmalen des unabhängigen Patentanspruchs 1 hat demgegenüber den Vorteil, dass zumindest eine Klemmeinrichtung vorgesehen ist, welche die mindestens eine Anschlussleitung nach dem Einführen in die Ausnehmung in der Ausnehmung fixiert.

Erfindungsgemäß umfasst die zumindest eine Klemmeinrichtung mindestens eine Riffelung, die beim Einführen der Anschlussleitung in die Ausnehmung plastisch verformt wird. Hierbei kann die Klemmeinrichtung beispielsweise eine in der Ausnehmung angeordnete Hülse umfassen, welche an ihrer Innenfläche zumindest teilweise eine Riffelung aufweist. Ein wesentlicher Vorteil der vorliegenden Erfindung besteht darin, dass die elektrische Anschlussleitung keine spezielle Oberfläche erfordert und beim Fügen eine sichere formschlüssige Verbindung der elektrischen Anschlussleitung mit der Klemmeinrichtung entsteht. Die Kontaktierung des elektrischen und/oder elektronischen Moduls mit dem Schaltungsträger erfolgt durch Einpressen der Anschlussleitung in die geriffelte Hülse. Dabei wird die Riffelung der Hülse plastisch verformt und es kommt zu einer formschlüssigen Verbindung zwischen der geriffelten Hülse und dem Anschlussdraht. Bei einer ausreichend gewählten Drahtlänge ist diese Art der Kontaktierung ebenfalls unempfindlich gegenüber Toleranzen. In vorteilhafter Weise werden hierdurch keine Anforderungen an die Zugänglichkeit der Kontaktstelle gestellt, wodurch auch bei dieser Ausführungsform ein so genanntes verdecktes Fügen der beiden Bauteile und somit die Einsparung von Montagekosten möglich ist. Durch die erfindungsgemäße Ausgestaltung der Klemmeinrichtung entfallen kosten- und zeitintensive Arbeitsschritte, wie beispielsweise Löten.

Ausführungsformen der vorliegenden Erfindung ermöglichen auf einfache und kostengünstige Weise eine sichere Direktkontaktierung des elektrischen und/oder elektronischen Moduls mit dem Schaltungsträger. Dies bedeutet, dass ein Direktsteckkontakt von der vorzugsweise als Draht ausgeführten Anschlussleitung des elektrischen und/oder elektronischen Moduls zum Schaltungsträger ermöglicht ist. Bei der Montage bzw. beim Fügen der beiden Bauteile wird die mindestens eine elektrische Anschlussleitung des elektrischen und/oder elektronischen Moduls in die Ausnehmung des Schaltungsträgers eingeführt und beim Einführen über die Klemmeinrichtung in der Ausnehmung fixiert. In vorteilhafter Weise werden hierdurch keine Anforderungen an die Zugänglichkeit der Kontaktstelle gestellt, wodurch ein so genanntes verdecktes Fügen der beiden Bauteile und dadurch eine vereinfachte Gesamtmontage der Anordnung möglich sind. Ein wesentlicher Vorteil der vorliegenden Erfindung liegt darin, dass die am elektrischen und/oder elektronischen Modul vorhandenen als Wicklungsdrähte bzw. als Phasenanschlüsse ausgeführten Anschlussleitungen ohne Zwischenkontaktierelemente, wie zum Beispiel so genannte Verschalteplatten, direkt mit dem Schaltungsträger verbunden werden können, unabhängig von der Anzahl der Drähte. Somit können in vorteilhafter Weise sämtliche notwendigen Komponenten direkt auf dem Schaltungsträger aufgebaut werden, wodurch sich eine gute Entwärmung ohne Toleranzproblematik ergibt. Ferner lässt die Anordnung auch größere Toleranzen, insbesondere bei der Einführtiefe bzw. der Einpresstiefe der Anschlussleitung, d.h. bei der Montage der beiden Bauteile zu. Zudem benötigen die Anschlussleitungen keine spezielle Oberfläche, so dass erhöhte Materialkosten bzw. aufwändige Bearbeitungsschritte entfallen können. In kommen, wo Anschlussleitungen bzw. Drähte elektrisch kontaktiert werden müssen.

Durch die in den abhängigen Ansprüchen aufgeführten Maßnahmen und Weiterbildungen sind vorteilhafte Verbesserungen der im unabhängigen Patentanspruch 1 angegebenen Anordnung mit einem elektrischen und/oder elektronischen Modul und einem Schaltungsträger möglich.

In Ausgestaltung der erfindungsgemäßen Anordnung ist die mindestens eine elektrische Anschlussleitung im Wesentlichen biegesteif ausgebildet. Vorzugsweise ist die mindestens eine elektrische Anschlussleitung hierzu von einem Halteelement versteifend umgeben. In vorteilhafter Weise ergibt sich hierdurch eine erhöhte Formstabilität der Anschlussleitung, welche die Montage des elektrischen und/oder elektronischen Moduls an den Schaltungsträger erheblich vereinfacht. Das Fügen der beiden Bauteile kann daher blind erfolgen, da sich die Anschlussleitung nicht verbiegen bzw. ausknicken und sich somit nicht an einer unerwarteten Stelle befinden kann. Insbesondere ist hierdurch eine sichere Kontaktierung der beiden Bauteile unabhängig von der Anzahl der Anschlussleitungen bzw. Drähte gewährleistet. Insgesamt ergibt sich eine einfache und sichere Montage des elektrischen und/oder elektronischen Moduls mit dem Schaltungsträger bei geringem Kraftaufwand.

Ferner umfaßt die Klemmeinrichtung eine Riffelung, welche die mindestens eine elektrische Anschlussleitung zumindest teilweise umgibt. Die Anschlussleitung lässt sich dann direkt in eine im Schaltungsträger angeordnete Hülse einpressen. In vorteilhafter Weise entsteht beim Einführen der elektrischen Anschlussleitung in die Klemmeinrichtung durch die plastische Verformung der Riffelung eine sichere formschlüssige Verbindung. Diese Kontaktiermethode ist bei geeignet gewählter Länge der Anschlussleitung bzw. geeignet gewählter Länge der Riffelung an der Anschlussleitung unempfindlich gegenüber Toleranzen, so dass auch hier keine besonderen Anforderungen an die Zugänglichkeit der Kontaktstelle gestellt werden und ein verdecktes Fügen der beiden Bauteile unter Einsparung von Montagekosten möglich ist. Zudem ist diese Kontaktiermethode sehr wirtschaftlich, da alle üblichen bekannten Nacharbeiten entfallen können.

In weiterer Ausgestaltung der erfindungsgemäßen Anordnung ist zumindest eine Zentriereinrichtung mit einem anschlussleitungsseitigen Zentrierkörper und einem mit dem anschlussleitungsseitigen Zentrierkörper zusammenwirkenden schaltungsträgerseitigen Zentrierkörper vorgesehen. In vorteilhafter Weise ist hierdurch eine schnelle und sichere Montage bzw. ein schnelles sicheres Fügen des elektrischen und/oder elektronischen Moduls und des Schaltungsträgers möglich, da die Anschlussleitung über die Zentriereinrichtung bei der Montage bzw. beim Fügen automatisch zentriert wird. Dadurch ist in vorteilhafter Weise ein sicheres Einführen der Anschlussleitung in die Ausnehmung und somit eine sichere Kontaktierung des Moduls mit dem Schaltungsträger gewährleistet.

Bevorzugt sind mehrere Zentrierkörper zu einer Baueinheit zusammengefasst. Die erfindungsgemäße Ausgestaltung ermöglicht eine kostengünstige Herstellung der Zentrierkörper sowie eine vereinfachte Montage der Zentrierkörper an der Anordnung, da hierbei nicht mehr einzelne Zentrierkörper hergestellt und montiert werden müssen.

Ausführungsbeispiele der Erfindung sind in den Zeichnungen dargestellt und werden in der nachfolgenden Beschreibung näher erläutert.

### Kurze Beschreibung der Zeichnungen

Fig. 1 zeigt eine schematische Schnittdarstellung eines Ausführungsbeispiels einer erfindungsgemäßen Anordnung mit einem elektrischen und/oder elektronischen Modul mit Anschlussleitungen und einem Schaltungsträger mit Ausnehmungen für die Aufnahme der Anschlussleitungen in einem unmontierten Zustand.
Fig. 2 zeigt eine schematische Schnittdarstellung der Anordnung aus Fig. 1 in einem montiertem Zustand.
Fig. 3 zeigt eine schematische Schnittdarstellung einer Anschlussleitung des elektrischen und/oder elektronischen Moduls, die von einem als Zentrierkörper ausgeführten Halteelement versteifend umgeben ist.
Fig. 4 zeigt eine schematische Schnittdarstellung einer über ein erstes Ausführungsbeispiels einer Klemmeinrichtung in einer Ausnehmung des Schaltungsträgers fixierten Anschlussleitung, wobei die Klemmeinrichtung als Rastscheibe ausgeführt und über der Klemmeinrichtung ein Zentrierkörper angeordnet ist.
Fig. 5 zeigt eine schematische Schnittdarstellung der als Rastscheibe ausgeführten Klemmeinrichtung aus Fig. 4, welche eine Anschlussleitung des elektrischen und/oder elektronischen Moduls in einer Ausnehmung des Schaltungsträgers fixiert.
Fig. 6 zeigt eine schematische Draufsicht der als Rastscheibe ausgeführten Klemmeinrichtung aus Fig. 4 und 5.
Fig. 7 zeigt eine schematisch Draufsicht von mehreren über jeweils einer als Rastscheibe ausgeführten Klemmeinrichtung angeordneten Zentrierkörpern, die zu einer viereckförmigen Baueinheit zusammengefasst sind.
Fig. 8 zeigt eine schematische Draufsicht von mehreren über jeweils einer als Rastscheibe ausgeführte Klemmeinrichtung angeordneten Zentrierkörpern, die zu einer bogenförmigen Baueinheit zusammengefasst sind.
Fig. 9 zeigt eine schematische Draufsicht von mehreren jeweils eine Anschlussleitung umgebende Haltelemente, die zu einer bogenförmigen Baueinheit zusammengefasst sind.
Fig. 10 zeigt eine schematische Draufsicht eines Schaltungsträgers mit einer elektrischen und/oder elektronischen Schaltungseinheit und einem zweiten Ausführungsbeispiel von Klemmeinrichtungen für die Anschlussleitungen des elektrischen und/oder elektronischen Moduls.
Fig. 11 zeigt eine schematische Draufsicht eines von einer Schutzmasse umgebenen Schaltungsträger mit dem zweiten Ausführungsbeispiel der Klemmeinrichtungenaus Fig. 10, wobei die Schutzmasse den Schaltungsträger unter Aussparung des Bereichs der Klemmeinrichtungen umgibt.
Fig. 12 zeigt eine schematische Schnittdarstellung eines dritten Ausführungsbeispiels einer Klemmeinrichtung, über welche eine Anschlussleitung in einer Ausnehmung des Schaltungsträgers fixiert ist.
Fig. 13 zeigt eine schematische perspektivische Darstellung der als Hülse mit Kragen ausgeführten Klemmeinrichtung aus Fig. 12.
Fig. 14 zeigt eine schematische Draufsicht der als Hülse mit Kragen ausgeführten Klemmeinrichtung aus Fig. 12 und 13, welche an ihrer Innenfläche eine Riffelung aufweist.
Fig. 15 zeigt eine schematische Schnittdarstellung eines vierten Ausführungsbeispiels einer Klemmeinrichtung, über welche eine Anschlussleitung in einer Ausnehmung des Schaltungsträgers fixiert ist.
Fig. 16 zeigt eine Seitenansicht der Klemmeinrichtung aus Fig. 15, welche als eine elektrische Anschlussleitung zumindest teilweise umgebende Riffelung ausgeführt ist.
Fig. 17 zeigt eine Draufsicht der Klemmeinrichtung aus Fig. 15 und 16.

### Ausführungsformen der Erfindung

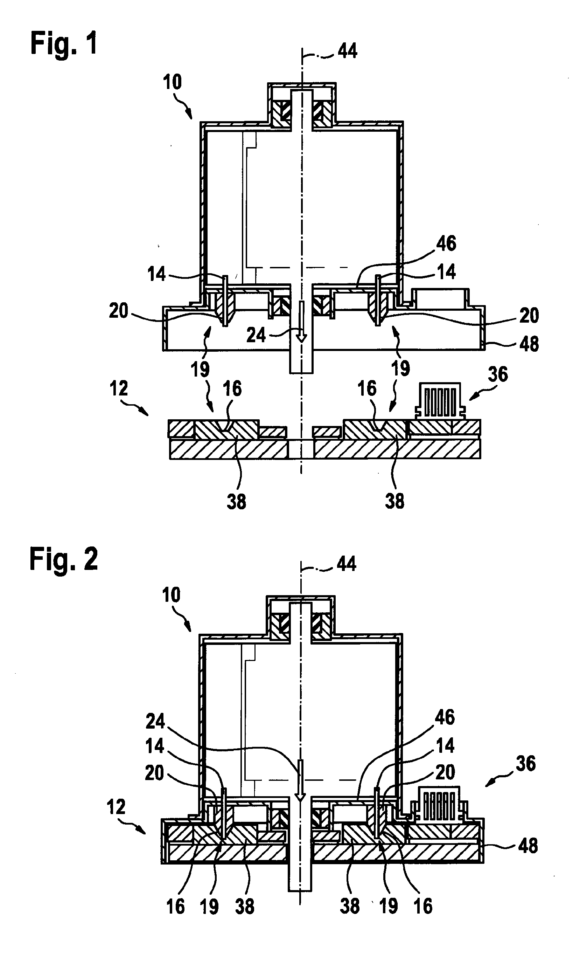

Wie aus Fig. 1 und 2 ersichtlich ist, umfasst eine beispielhafte Anordnung ein elektrisches und/oder elektronisches Modul 10 und einen Schaltungsträger 12, bei welcher mindestens eine elektrische Anschlussleitung 14 des elektrischen und/oder elektronischen Moduls 10 in einer Ausnehmung 16 des Schaltungsträgers 12 aufnehmbar ist. In den vorliegenden Beispielen handelt es sich bei dem elektrischen und/oder elektronischen Modul 10 um einen Elektromotor und bei der elektrischen Anschlussleitung 14 um einen Spulendraht des Elektromotors. Vorzugsweise umfasst der Schaltungsträger 12 eine Leiterplatte und/oder ein Substrat. Bevorzugt ist das Substrat als Kunststoffsubstrat oder als Keramiksubstrat ausgeführt. In den vorliegenden Beispielen ist der Schaltungsträger 12 vorzugsweise plattenförmig und im Umriss bevorzugt rechteckig ausgeführt.

In vorteilhafter Weise umfasst das elektrische und/oder elektronische Modul 10 ein über einen Bodenbereich 46 des elektrischen und/oder elektronischen Moduls 10 überstehendes und an dem elektrischen und/oder elektronischen Modul 10 befestigtes Gehäuseelement 48 zur Aufnahme des Schaltungsträgers 12.

Wie aus Fig. 1,2, 10 und 11 ersichtlich, ist auf dem Schaltungsträger 12 mindestens eine elektrische und/oder elektronische Schaltungseinheit 36 montiert. Ebenfalls weist der Schaltungsträger 12 zwei Ausnehmungen 16 für den elektrischen Anschluss des elektrischen und/oder elektronischen Moduls 10 bzw. zur Aufnahme der elektrischen Anschlussleitungen 14 des elektrischen und/oder elektronischen Moduls 10 auf. In den vorliegenden Beispielen sind die Ausnehmungen 16 als durchgehende Durchstecköffnungen ausgebildet.

Um eine direkte und sichere Kontaktierung der mindestens einen Anschlussleitung 14 des elektrischen und/oder elektronischen Moduls 10 mit dem Schaltungsträger 12 ohne zusätzliche Kontaktierelemente sowie ein verdecktes Fügen der beiden Bauteile 10, 12 zu ermöglichen, umfasst die Anordnung erfindungsgemäß zumindest eine Klemmeinrichtung 18a, 18b, 18c und 18d, welche die mindestens eine Anschlussleitung 14 nach dem Einführen in die Ausnehmung 16 in der Ausnehmung 16 fixiert.

Um ein blindes Fügen bzw. Montieren des elektrischen und/oder elektronischen Moduls 10 und des Schaltungsträgers 12 zu ermöglichen, indem ein Verbiegen bzw. Ausknicken der Anschlussleitungen 14 des Moduls 10 beim Füge- bzw. Montagevorgang verhindert wird, ist die mindestens eine elektrische Anschlussleitung 14 im Kontaktierbereich im Wesentlichen biegesteif ausgebildet. Hierzu ist die mindestens eine elektrische Anschlussleitung 14 von einem in Fig. 1 bis 4 dargestellten Halteelement 20 versteifend umgeben. Das Halteelement 20 dient zur axialen Führung der Anschlussleitung 14 und ist bevorzugt als Kunststoffteil ausgeführt. Im vorliegenden Beispiel ist das Halteelement 20 an dem zur Aufnahme des Schaltungsträgers 12 dienenden Gehäuseelement 48 des elektrischen und/oder elektronischen Moduls 10 befestigt.

Vorzugsweise ist das Halteelement 20 auf die Anschlussleitung 14 aufgepresst. Hierdurch wird das freie Ende der elektrischen Anschlussleitung 14 durch das Halteelement 20 in vorteilhafter Weise besonders gut versteift und somit axial geführt, so dass die elektrische Anschlussleitung 14 eine Unterstützung bezüglich der Formstabilität erhält und dadurch gegen Biegen bzw. Knicken bei der Montage der beiden Bauteile 10, 12 gesichert ist. Bei der Montage wird zunächst das Halteelement 20 über die Anschlussleitung 14 bzw. den Anschlussdraht aufgeschoben. Der Anschlussdraht 14 wird dann abisoliert. Anschließend wird das Ende des Anschlussdrahtes 14 geformt, indem dieses zur axialen Sicherung des Halteelementes 20 und zur Bildung einer Einführspitze einer Verprägung unterzogen wird. Abschließend wird der Anschlussdraht 14 abgelängt.

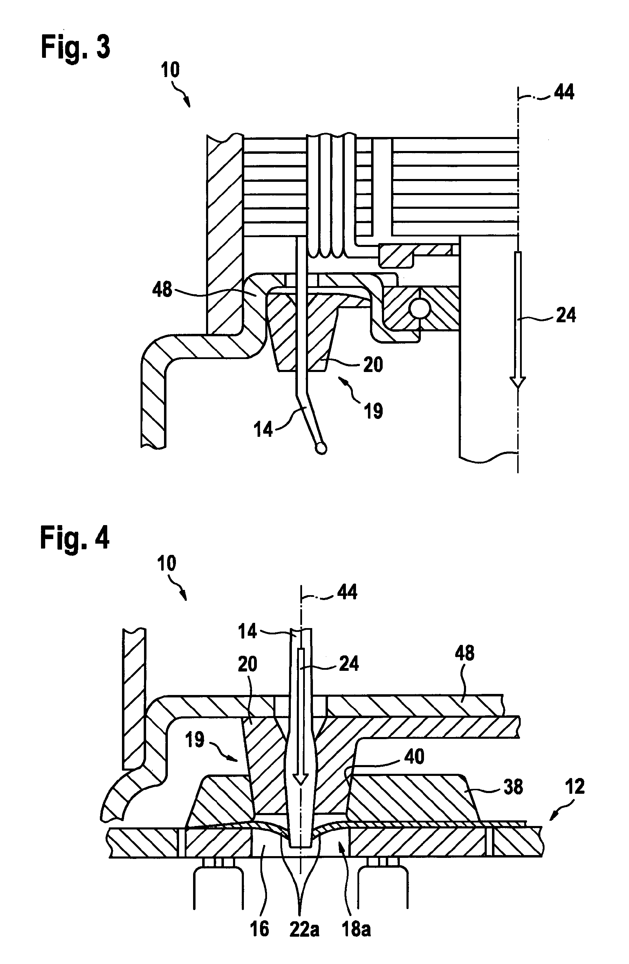

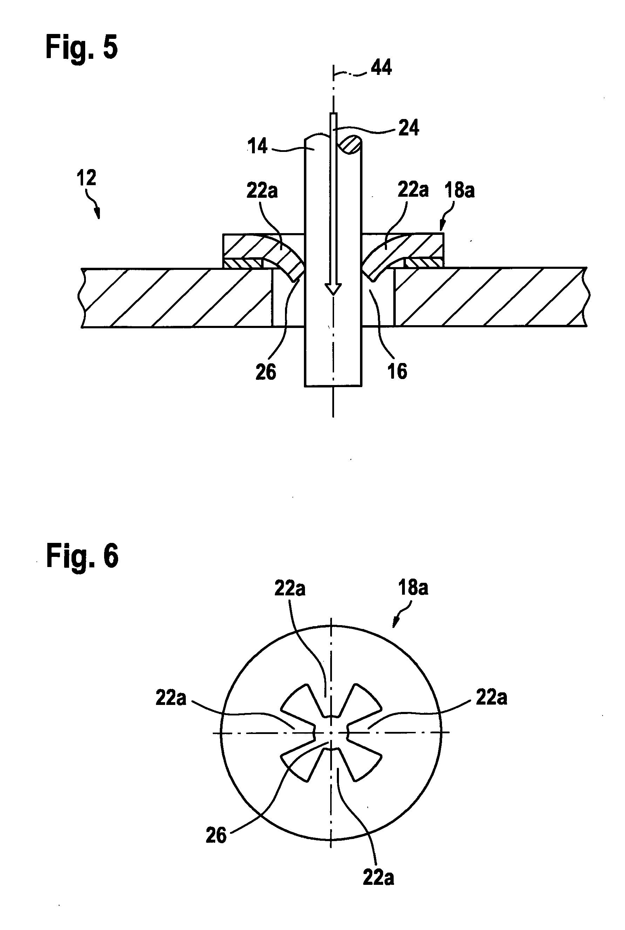

Gemäß einem in Fig. 4 bis 11 dargestellten, Wirkprinzip umfasst die zumindest eine Klemmeinrichtung 18a, 18b mindestens eine federelastisch verformbare Zunge 22a, 22b, die sich beim Einführen der Anschlussleitung 14 in die Ausnehmung 16 in Einführungsrichtung 24 verbiegt.

In einer beispielhaften Variante gemäß Fig. 4 bis 6 umfasst die zumindest eine Klemmeinrichtung ein Rastscheibenelement 18a mit einer mit mehreren federelastisch verformbaren Zungen 22a versehenen Durchtrittsöffnung 26, welches die Ausnehmung 16 überdeckend an dem Schaltungsträger 12 anliegt. Das Rastscheibenelement 18a lässt sich durch einen einfachen Stanzprozess herstellen, wobei aus einer kreisförmigen Scheibe eine kleeblattförmige Struktur ausgestanzt wird, so dass mehrere federelastisch verformbare Zungen 22a stehen bleiben. Das Rastscheibenelement 18a wird so auf den Schaltungsträger 12 gelötet, dass das Zentrum des Rastscheibenelements 18a bzw. die Durchtrittsöffnung 26 des Rastscheibenelements 18a über der Ausnehmung 16 des Schaltungsträgers 12 liegt. Durch dieses Zentrum bzw. diese Durchtrittsöffnung 26 des Rastscheibenelements 18a kann dann die Anschlussleitung 14 eingepresst werden. Dabei verformen sich die Zungen 22a des Rastscheibenelements 18a und es kommt zu einer formschlüssigen Verbindung zwischen dem Rastscheibenelement 18a und der Anschlussleitung 14 bzw. dem Anschlussdraht.

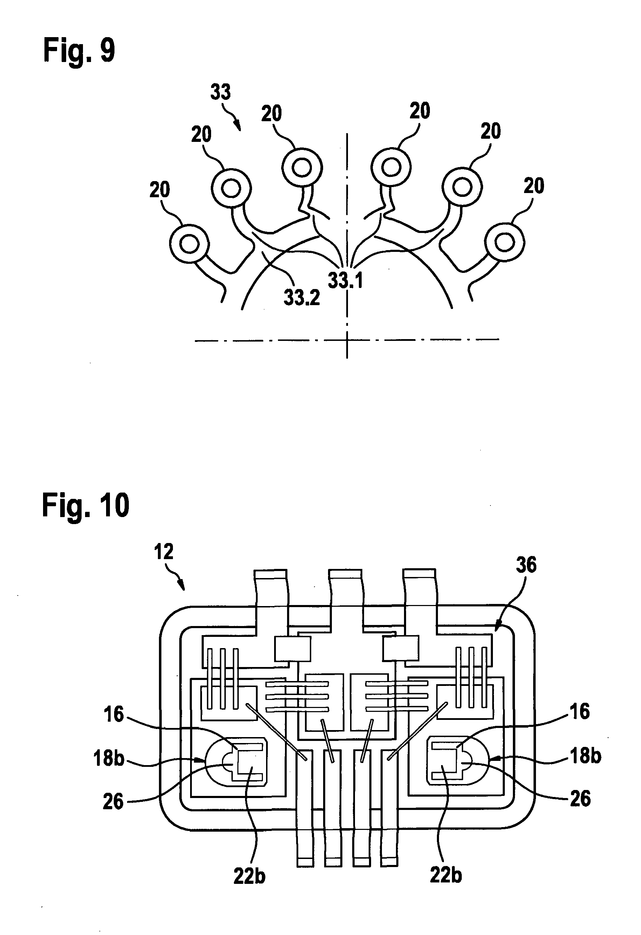

In einer zweiten beispielhaften Variante gemäß Fig. 10 bis 11 umfasst die zumindest eine Klemmeinrichtung eine im Schaltungsträger 12 angeordnete Kontur 18b, welche mindestens eine federelastisch verformbare Zunge 22b ausbildet. Hierbei können die Anschlussleitungen 14 bzw. Anschlussdrähte direkt in die integrierten Konturen 18b des Schaltungsträgers 12 gesteckt bzw. eingeführt werden. Vorzugsweise ist die mindestens eine Kontur 18b in einem vorzugsweise mit Kunststoff umspritzten Stanzgitter des Schaltungsträgers 12 ausgebildet.

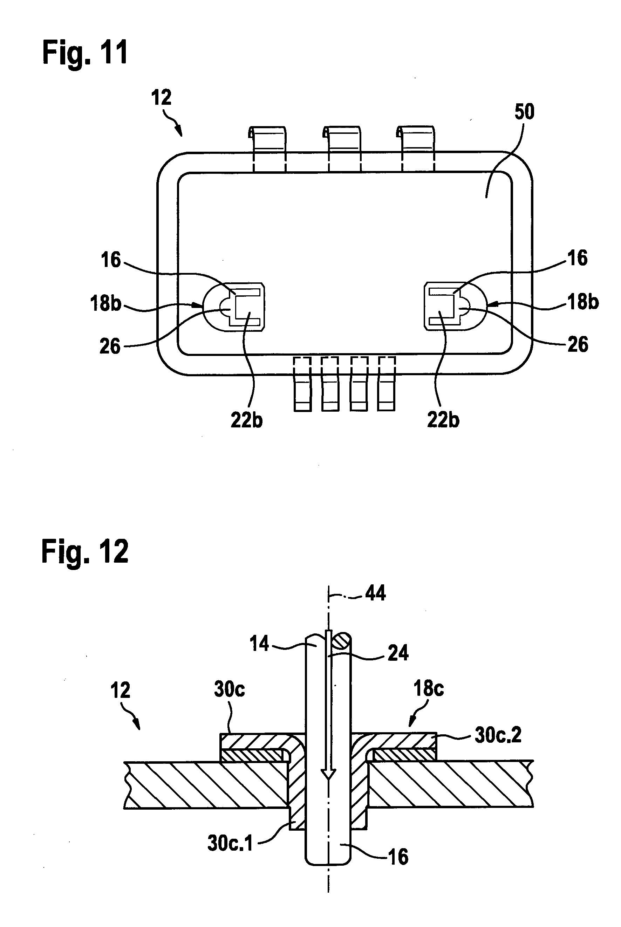

Fig. 11 zeigt einen von einer Schutzmasse 50 umgebenen Schaltungsträger 12 mit Klemmeinrichtungen 18b, wobei die Schutzmasse 50 den Schaltungsträger 12 unter Aussparung des Bereichs der Klemmeinrichtungen 18b umgibt.

In vorteilhafter Weise weist die Anordnung gemäß Fig. 1, 2, 4, 7 und 8 zumindest eine Zentriereinrichtung 19 mit einem anschlussleitungsseitigen Zentrierkörper 20 und einem mit dem anschlussleitungsseitigen Zentrierkörper 20 zusammenwirkenden schaltungsträgerseitigen Zentrierkörper 38 auf. In den vorliegenden Beispielen ist das als Versteifungselement für die Anschlussleitung 14 vorgesehene Halteelement 20 gleichzeitig als Teil der erfindungsgemäßen Zentriereinrichtung 19 bzw. als anschlussleitungsseitiger Zentrierkörper 20 der Zentriereinrichtung 19 ausgebildet. Der schaltungsträgerseitige mit einer Durchgangsöffnung 40 versehene Zentrierkörper 38 ist derart in einem Bereich der Klemmeinrichtung 18a, 18b, 18c, 18d angeordnet, dass seine Durchgangsöffnung 40 zu der Ausnehmung 16 des Schaltungsträgers 12 fluchtet. Bei der Montage der beiden Bauteile 10, 12 wird der anschlussleitungsseitige Zentrierkörper 20 zumindest teilweise im schaltungsträgerseitigen Zentrierkörper 38 aufgenommen.

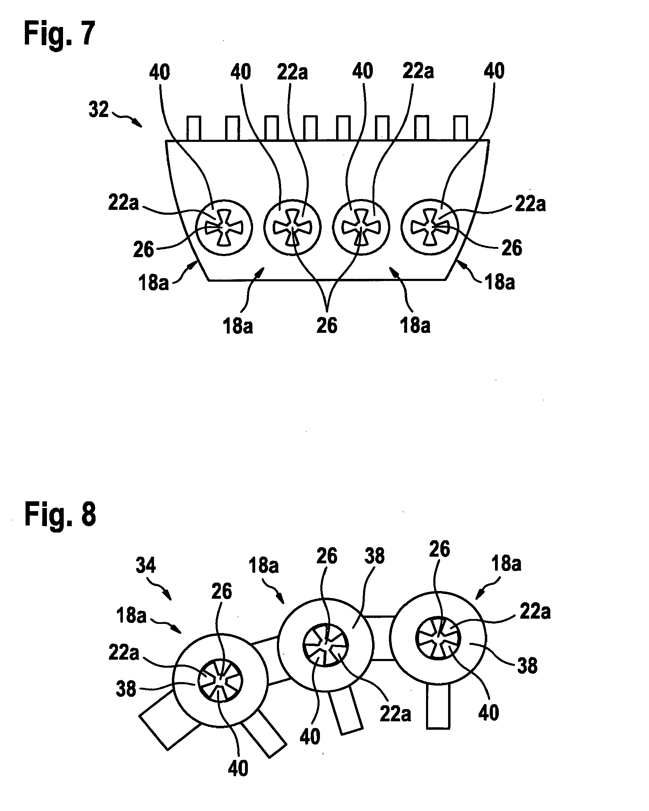

Wie aus Fig. 7 bis 9 ersichtlich, können mehrere Zentrierkörper 20, 38 zu einer Baueinheit 32, 33, 34 zusammengefasst sein. So zeigt Fig. 7 mehrere in einer Reihe angeordnete schaltungsträgerseitige Zentrierkörper, die zu einer viereckförmigen Baueinheit 32 zusammengefasst sind. Fig. 8 zeigt mehrere kreisbogenförmig angeordnete schaltungsträgerseitige Zentrierkörper 38, die zu einer bogenförmigen Baueinheit 34 zusammengefasst sind, wobei auch eine ringförmige Baueinheit vorstellbar wäre. Fig. 9 zeigt mehrere bogenförmig angeordnete anschlussleitungsseitige Zentrierkörper 20, die zu einer bogenförmigen Baueinheit 33 zusammengefasst sind, wobei auch eine ringförmige Baueinheit vorstellbar wäre. Die einzelnen Zentrierkörper 20 sind dabei über mäanderförmige Strukturen 33.1 miteinander und mit einem Bogen 33.2 bzw. Ring der Baueinheit 33 verbunden.

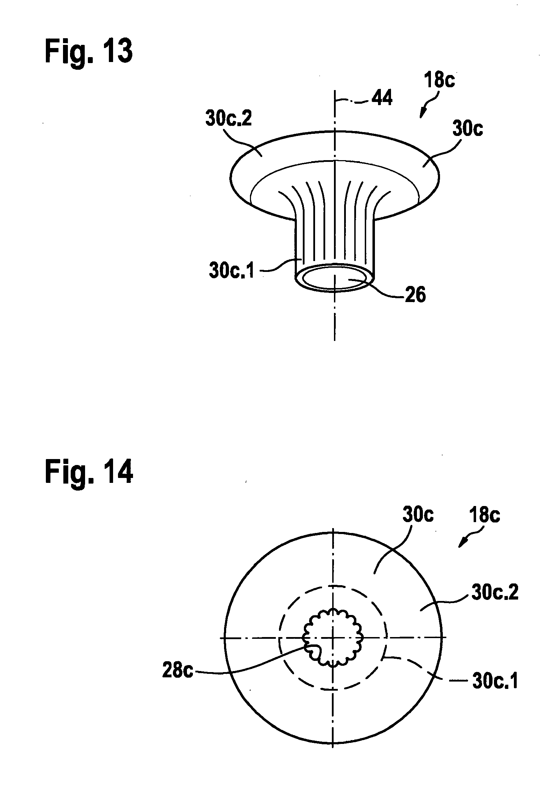

Gemäß einer in Fig. 12 bis 17 dargestellten Ausführungsform der Erfindung, umfasst die zumindest eine Klemmeinrichtung 18c, 18d mindestens eine Riffelung 28c, 28d die beim Einführen der Anschlussleitung 14 in die Ausnehmung 16 plastisch verformt wird.

In einer ersten Variante des Wirkprinzips der Erfindung gemäß Fig.12 bis 14 umfasst die zumindest eine Klemmeinrichtung 18c eine in der Ausnehmung 16 angeordnete Hülse 30c, welche an ihrer Innenfläche zumindest teilweise eine Riffelung 28c aufweist. Die Hülse 30c lässt sich durch Stanzen, Tiefziehen und Abprägen herstellen. Ihr Innendurchmesser ist geringfügig kleiner als der Außendurchmesser der zu kontaktierenden Anschlussleitung 14. Vorzugsweise ist die Ausrichtung der angeprägten Riffelung 28c parallel zu einer Längsachse 44 der Hülse 30c. Vorzugsweise weist die Hülse 30c einen hülsenförmigen, mit der Riffelung 28c versehenen Teil 30c.1 auf, an welchen sich ein Kragen 30c.2 anschließt. Die geriffelte Hülse 30c wird mit ihrem hülsenförmigen Teil 30c.1 in die Ausnehmung 16 eingebracht und über ihren Kragen 30c.2 auf den Schaltungsträger 12 gelötet. Die Anschlussleitung 14 wird in die Hülse 30c eingepresst. Dabei wird die Riffelung 28c der Hülse 30c plastisch verformt und es kommt zu einer formschlüssigen Verbindung zwischen der geriffelten Hülse 30c und der Anschlussleitung 14.

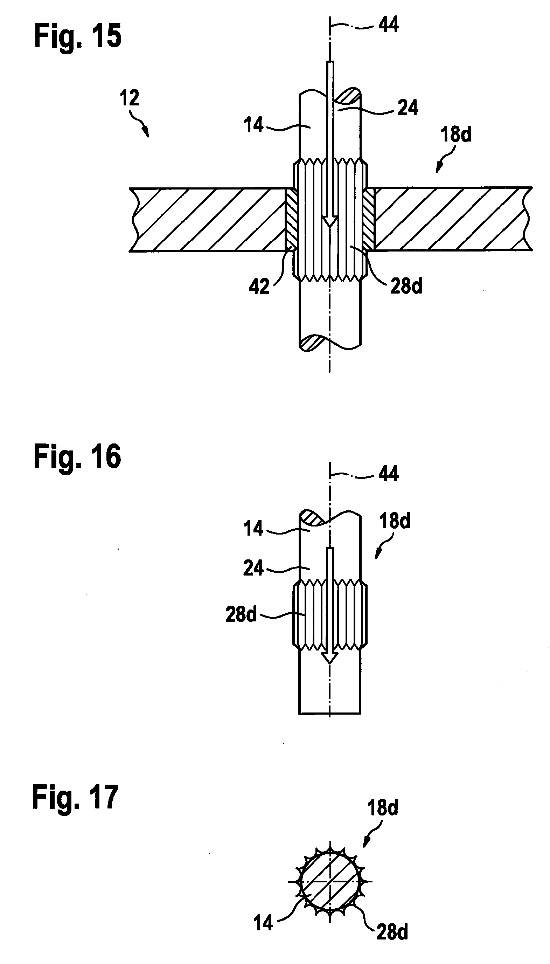

In einer zweiten Variante des Wirkprinzips der Erfindung gemäß Fig. 15 bis 17 umfasst die zumindest eine Klemmeinrichtung 18d eine Riffelung 28d, welche die mindestens eine elektrische Anschlussleitung 14 zumindest teilweise umgibt. Hierzu wird die Anschlussleitung bzw. der Anschlussdraht 14 entsprechend bearbeitet, vorzugsweise geprägt und mit einer Riffelung 28d versehen. Die mit der Riffelung 28d versehene Anschlussleitung 14 lässt sich dann direkt in eine im Schaltungsträger 12 eingebrachte Steckhülse 42 oder direkt in den Schaltungsträger 12 einpressen. Auch hier kommt es durch die plastische Verformung der Riffelung 28d zu einer formschlüssigen Verbindung.

Bei der Montage bzw. beim Fügen der beiden Bauteile 10, 12 wird die mindestens eine elektrische Anschlussleitung 14 des elektrischen und/oder elektronischen Moduls 10 in die Ausnehmung 16 des Schaltungsträgers 12 eingeführt und beim Einführen über die Klemmeinrichtung 18a , 18b, 18c, 18d in der Ausnehmung 16 fixiert. In vorteilhafter Weise werden alle elektrische Anschlussleitungen 14 des elektrischen und/oder elektronischen Moduls 10 in einem Arbeitsschritt in jeweils eine Ausnehmung 16 des Schaltungsträgers 12 eingeführt und beim Einführen über die erfindungsgemäße Klemmeinrichtung 18a, 18b, 18c, 18d in der Ausnehmung 16 fixiert.

## Patentansprüche

1. Anordnung mit einem elektrischen und/oder elektronischen Modul (10) und einem Schaltungsträger (12), bei welcher mindestens eine elektrische Anschlussleitung (14) des elektrischen und/oder elektronischen Moduls (10) in einer Ausnehmung (16) des Schaltungsträgers (12) aufgenommen ist, wobei zumindest eine Klemmeinrichtung (18a, 18b, 18c, 18d) die mindestens eine Anschlussleitung (14) nach dem Einführen in die Ausnehmung (16) in der Ausnehmung (16) fixiert, **dadurch gekennzeichnet, dass** die zumindest eine Klemmeinrichtung (18c, 18d) mindestens eine Riffelung (28c, 28d) umfasst, die beim Einführen der Anschlussleitung (14) in die Ausnehmung (16) plastisch verformt wird.

2. Anordnung nach Anspruch 1, **dadurch gekennzeichnet, dass** die mindestens eine elektrische Anschlussleitung (14) im Wesentlichen biegesteif ausgebildet ist.

3. Anordnung nach Anspruch 1 oder 2, **dadurch gekennzeichnet, dass** die zumindest eine Klemmeinrichtung (18c) eine in der Ausnehmung (16) angeordnete Hülse (30c) umfasst, welche an ihrer Innenfläche zumindest teilweise eine Riffelung (28c) aufweist.

4. Anordnung nach einem der Ansprüche 1 oder 2, **dadurch gekennzeichnet, dass** die zumindest eine Klemmeinrichtung (18d) eine Riffelung (28d) umfasst, welche die mindestens eine elektrische Anschlussleitung (14) zumindest teilweise umgibt.

5. Anordnung nach einem der Ansprüche 1 bis 4, **gekennzeichnet durch** zumindest eine Zentriereinrichtung (19) mit einem anschlussleitungsseitigen Zentrierkörper (20) und einem mit dem anschlussleitungsseitigen Zentrierkörper (20) zusammenwirkenden schaltungsträgerseitigen Zentrierkörper (38).

6. Anordnung nach einem der Ansprüche 1 bis 5, **dadurch gekennzeichnet, dass** mehrere Zentrierkörper (20, 38) zu einer Baueinheit (32, 33, 34) zusammengefasst sind.

## Claims

1. Arrangement comprising an electric and/or electronic module (10) and a circuit carrier (12), in which at least one electric connecting line (14) of the electric and/or electronic module (10) is accommodated in a recess (16) of the circuit carrier (12), wherein at least one clamping device (18a, 18b, 18c, 18d) fixes the at least one connecting line (14) in the recess (16) after being introduced into the recess (16), **characterized in that** the at least one clamping device (18c, 18d) comprises at least one ribbing (28c, 28d) which is plastically deformed when the connecting line (14) is introduced into the recess (16).

2. Arrangement according to Claim 1, **characterized in that** the at least one electric connecting line (14) is of substantially flexurally rigid design.

3. Arrangement according to Claim 1 or 2, **characterized in that** the at least one clamping device (18c) comprises a sleeve (30c) which is arranged in the recess (16) and at least part of the inner surface of which has a ribbing (28c).

4. Arrangement according to either of Claims 1 and 2, **characterized in that** the at least one clamping device (18d) comprises a ribbing (28d) which at least partially surrounds the at least one electric connecting line (14).

5. Arrangement according to one of Claims 1 to 4, **characterized by** at least one centering device (19) with a centering body (20) on the connecting line side and a centering body (38) which is on the circuit carrier side and interacts with the centering body (20) on the connecting line side.

6. Arrangement according to one of Claims 1 to 5, **characterized in that** a plurality of centering bodies (20, 38) are combined to form a constructional unit (32, 33, 34).

## Revendications

1. Ensemble comportant un module (10) électrique et/ou électronique et un support de circuit (12), dans lequel au moins une ligne de raccordement électrique (14) du module (10) électrique et/ou électronique est reçue dans un évidement (16) du support de circuit (12), au moins un dispositif de serrage (18a, 18b, 18c, 18d) fixant l'au moins une ligne de raccordement (14) dans l'évidement (16) après l'introduction dans l'évidement (16), **caractérisé en ce que** l'au moins un dispositif de serrage (18c, 18d) comporte au moins un cannelage (28c, 28d) qui est déformé plastiquement lors de l'introduction de la ligne de raccordement (14) dans l'évidement (16).

2. Ensemble selon la revendication 1, **caractérisé en ce que** l'au moins une ligne de raccordement électrique (14) est réalisée de manière essentiellement résistante à la flexion.

3. Ensemble selon la revendication 1 ou 2, **caractérisé en ce que** l'au moins un dispositif de serrage (18c) comporte une douille (30c) disposée dans l'évidement (16), laquelle comprend au moins partiellement sur sa surface intérieure un cannelage (28c).

4. Ensemble selon l'une quelconque des revendications 1 et 2, **caractérisé en ce que** l'au moins un dispositif de serrage (18d) comporte un cannelage (28d), lequel entoure au moins partiellement l'au moins une ligne de raccordement électrique (14).

5. Ensemble selon l'une quelconque des revendications 1 à 4, **caractérisé par** au moins un dispositif de centrage (19) comprenant un corps de centrage (20) situé du côté de la ligne de raccordement et un corps de centrage (38) situé du côté du support de circuit et coopérant avec le corps de centrage (20) situé du côté de la ligne de raccordement.

6. Ensemble selon l'une quelconque des revendications 1 à 5, **caractérisé en ce que** plusieurs corps de centrage (20, 38) sont rassemblés pour former une unité structurale (32, 33, 34).
